(19) Europäisches Patentamt
European Patent Office
Office européen des brevets

(11) **EP 4 130 108 A1**

(12) **EUROPEAN PATENT APPLICATION**
published in accordance with Art. 153(4) EPC

(43) Date of publication:
**08.02.2023 Bulletin 2023/06**

(21) Application number: **21774877.1**

(22) Date of filing: **26.03.2021**

(51) International Patent Classification (IPC):
***C08J 5/18*** *(1974.07)* ***C08J 7/04*** *(1974.07)*
***C08J 7/046*** *(2020.01)*

(52) Cooperative Patent Classification (CPC):
**C08J 5/18; C08J 7/04; C08J 7/046**

(86) International application number:
**PCT/KR2021/003804**

(87) International publication number:
**WO 2021/194317 (30.09.2021 Gazette 2021/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.03.2020 KR 20200037090**

(71) Applicant: **Kolon Industries, Inc.**
**Seoul 07793 (KR)**

(72) Inventors:
- **JUNG, Hak-Gee**
  **Seoul 07793 (KR)**
- **AHN, Sang-Hyun**
  **Seoul 07793 (KR)**
- **SHIN, Hyora**
  **Seoul 07793 (KR)**

(74) Representative: **Ter Meer Steinmeister & Partner Patentanwälte mbB**
**Nymphenburger Straße 4**
**80335 München (DE)**

(54) **OPTICAL FILM HAVING EXCELLENT IMPACT RESISTANCE AND DISPLAY DEVICE COMPRISING SAME**

(57) The present disclosure provides an optical film comprising: a light-transmitting substrate; and a buffer layer, wherein a first impact resistance parameter calculated by equation 1 is 0.08 or higher, and a display device comprising the optical film.

FIG. 1

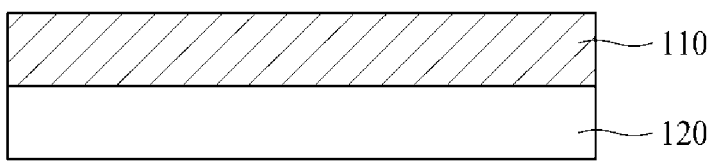


EP 4 130 108 A1

## Description

[Technical Field]

The present disclosure relates to an optical film having improved impact resistance and a display device including the same.

[Background Art]

Recently, the use of an optical film instead of glass as a cover window of a display device has been considered with the goal of reducing the thickness and weight and increasing the flexibility of the display device. In order for the optical film to be usable as a cover window of a display device, the optical film needs to have superior optical properties and excellent mechanical properties.

Therefore, there is a need for the development of films having excellent optical properties as well as superior mechanical properties such as insolubility, chemical resistance, heat resistance, radiation resistance and low temperature characteristics. The development of an optical film that has excellent impact properties and leaves no folding marks (creases) behind after folding is required.

A polyimide (PI)-based resin, which is a typical material for optical films, has superior insolubility, chemical resistance, heat resistance, radiation resistance, low-temperature characteristics, bendability, impact resistance, and the like, and is thus used as automobile materials, aviation materials, spacecraft materials, insulating coatings, insulating films, protective films and the like.

[Disclosure]

[Technical Problem]

Therefore, the present disclosure has been made in view of the above problems, and it is one aspect of the present disclosure to provide an optical film that includes a novel buffer layer and thus exhibits improved impact resistance in spite of small thickness thereof.

It is another aspect of the present disclosure to provide a display device including the optical film that exhibits improved impact resistance.

[Technical Solution]

In accordance with one aspect of the present disclosure, provided is an optical film including a light-transmitting substrate and a buffer layer, the optical film having a first impact resistance parameter calculated by the following Equation 1, of 0.08 or more:

[Equation 1]

First impact resistance parameter = [{(thickness of light-transmitting substrate x 1.5) + (restoration rate of light-transmitting substrate x 0.01 x 1.5) + (thickness of buffer layer x 2) + (restoration rate of buffer layer x 0.01 x 1.5)} x (restoration rate of optical film x 0.01 x 2) x puncture strength of optical film] / (thickness of optical film)$^2$

wherein the restoration rate (nIT; 12 mN) of the light-transmitting substrate, the buffer layer and the optical film are measured under the conditions of 12 mN/12s/Creep 5s/24°C, 40RH% using a Nanoindentation tester (model HM2000 from Fischer Corporation), and the puncture strength is measured using a model S1-11855 from Instron Corp. (probe size: 3.18 mm) in accordance with the standard ASTM D4830.

The buffer layer may include a urethane acrylate resin.

The buffer layer may include a urethane acrylate siloxane resin.

The urethane acrylate siloxane resin may include a urethane acrylate silane compound represented by the following Formula 1, an alkoxysilane compound represented by the following Formula 2, and a diol compound represented by the following Formula 3:

[Formula 1]

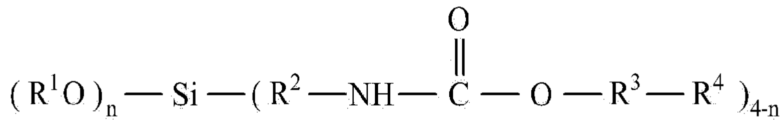

wherein $R^1$ is a functional group derived from a C1-C8 aliphatic or aromatic hydrocarbon, $R^2$ and $R^3$ are each independently a C1-C6 linear, branched, or alicyclic alkylene group, $R^4$ is an acrylate group or methacrylate group, and n is an integer of 1 to 3,

[Formula 2] $R^5_mSi(OR^6)_{4-m}$

wherein $R^5$ and $R^6$ are each independently a functional group derived from a C1-C8 aliphatic or aromatic hydrocarbon, and m is an integer of 0 to 3,

[Formula 3] $HO-R^7-OH$

wherein $R^7$ is a functional group derived from a C1-C6 aliphatic or aromatic hydrocarbon.

$R^4$ may be an acrylate group including a hydroxyl group (-OH) .

$R^4$ may be an acrylate group derived from one of 2-hydroxyethyl acrylate (2-HEA) and 4-hydroxybutyl acrylate (4-HBA) .

The alkoxysilane compound may include tetraalkoxysilane.

The diol compound may include ethylene glycol.

The buffer layer may have a thickness of 10 to 150 μm.

The light-transmitting substrate may have a thickness of 10 to 100 μm.

The optical film may have a restoration rate (nIT) of 60 to 100% based on 12 mN.

The optical film may further include a hard coating layer, wherein the optical film has a second impact resistance parameter calculated by the following Equation 2, of 0.08 or more:

[Equation 2]

Second impact resistance parameter = [{(thickness of light-transmitting substrate x 1.5) + (restoration rate of light-transmitting substrate x 1.5 x 0.01) + (thickness of buffer layer x 2) + (restoration rate of buffer layer x 1.5 x 0.01)} + (thickness of hard coating layer X 1) + (restoration rate of hard coating layer x 0.01 x 1)} x (restoration rate of optical film x 0.01 x 2) x puncture strength of optical film] / (thickness of optical film)$^2$

wherein the restoration rates (nIT; 12 mN) of the light-transmitting substrate, the buffer layer, the hard coating layer and the optical film are measured under the conditions of 12 mN/12s/Creep 5s/24°C, 40RH% using a Nanoindentation tester (model HM2000 from Fischer Corporation) and the puncture strength is measured using model S1-11855 from Instron Corp. (probe size: 3.18 mm) in accordance with the standard ASTM D4830.

The hard coating layer may have a thickness of 0.1 to 10 μm.

In accordance with another aspect of the present disclosure, provided is a display device including a display panel and the optical film disposed on the display panel.

[Advantageous Effects]

One embodiment of the present disclosure provides an optical film that exhibits improved impact resistance by including a buffer layer.

Another embodiment of the present disclosure provides a display device including the optical film that exhibits improved impact resistance.

[Description of Drawings]

FIG. 1 is a cross-sectional view illustrating an optical film according to an embodiment of the present disclosure;

FIG. 2 is a cross-sectional view illustrating an optical film according to another embodiment of the present disclosure;

FIG. 3 is a cross-sectional view illustrating an optical film according to another embodiment of the present disclosure, further including a hard coating layer;

FIG. 4 is a cross-sectional view illustrating an optical film according to another embodiment of the present disclosure, further including a hard coating layer;

FIG. 5 is a cross-sectional view illustrating an optical film according to another embodiment of the present disclosure, further including a hard coating layer;

FIG. 6 is a cross-sectional view of a part of a display device according to still another embodiment of the present disclosure; and

FIG. 7 is an enlarged cross-sectional view illustrating part "P" of FIG. 6.

[Best Mode]

Hereinafter, embodiments of the present disclosure will be described in detail with reference to the accompanying drawings. However, the following embodiments are provided illustratively merely for clear understanding of the present disclosure, and do not limit the scope of the present disclosure.

The shapes, sizes, ratios, angles, and numbers disclosed in the drawings for describing embodiments of the present disclosure are merely examples, and the present disclosure is not limited to the illustrated details. Like reference numerals refer to like elements throughout the present specification. In the following description, when a detailed description of relevant known functions or configurations is determined to unnecessarily obscure important points of the present disclosure, the detailed description will be omitted.

In the case in which the term such as "comprise", "have", or "include" is used in the present specification, another part may also be present, unless "only" is used. Terms in a singular form may include the plural meanings unless noted to the contrary. Also, in construing an element, the element is to be construed as including an error range even if there is no explicit description thereof.

In describing a positional relationship, for example, when the positional relationship is described as "on", "above", "below", or "next", the case of no contact therebetween may be included, unless "just" or "directly" is used.

Spatially relative terms such as "below", "beneath", "lower", "above", and "upper" may be used herein to describe the relationship of a device or an element to another device or another element as shown in the figures. It will be understood that spatially relative terms are intended to encompass different orientations of a device during the use or operation of the device, in addition to the orientation depicted in the figures. For example, if a device in one of the figures is turned upside down, elements described as "below" or "beneath" other elements would then be positioned "above"

the other elements. The exemplary term "below" or "beneath" can, therefore, encompass the meanings of both "below" and "above". In the same manner, the exemplary term "above" or "upper" can encompass the meanings of both "above" and "below".

In describing temporal relationships, for example, when the temporal order is described using "after", "subsequent", "next", or "before", the case of a non-continuous relationship may be included, unless "just" or "directly" is used.

It will be understood that, although the terms "first", "second", etc. may be used herein to describe various elements, these elements should not be limited by these terms. These terms are only used to distinguish one element from another. Therefore, a first element could be termed a second element within a technical idea of the present disclosure.

It should be understood that the term "at least one" includes all combinations related with any one item. For example, "at least one among a first element, a second element, and a third element" may include all combinations of two or more elements selected from among the first, second, and third elements, as well as each of the first, second, and third elements.

Features of various embodiments of the present disclosure may be partially or completely coupled to or combined with each other, and may be variously interoperated with each other and driven technically, as will be easily understood by those skilled in the art. The embodiments of the present disclosure may be carried out independently from each other, or may be carried out together in an interrelated manner.

FIG. 1 is a sectional view illustrating an optical film according to an embodiment of the present disclosure, and FIG. 2 is a sectional view illustrating an optical film according to another embodiment of the present disclosure.

One embodiment of the present disclosure provides an optical film. The optical film according to the embodiment of the present disclosure includes a light-transmitting substrate 110 and a buffer layer 120. As shown in FIG. 1, in the optical film of the present disclosure, the buffer layer 120 may be formed on the lower surface of the light-transmitting substrate 110. However, the present disclosure is not limited thereto, and, as shown in FIG. 2, in the optical film of the present disclosure, the buffer layer 120 may be formed on the upper surface of the light-transmitting substrate 110. Alternatively, although not shown in the drawings, the buffer layer 120 may be disposed on both the upper and lower surfaces of the light-transmitting substrate 110. The buffer layer 120 may be disposed at any position as needed, and another layer may be formed between the light-transmitting substrate 110 and the buffer layer 120. However, when the buffer layer 120 is formed on the upper surface of the light-transmitting substrate 110, the hardness of the buffer layer 120 is low, and the durability and scratch resistance of the optical film may decrease. Thus, it is preferable that the buffer layer 120 be formed on the lower surface of the light-transmitting substrate 110.

The light-transmitting substrate 110 according to an embodiment of the present disclosure may be any type of material capable of transmitting light. For example, the light-transmitting substrate 110 may include glass or a polymer resin. In particular, the polymer resin is suitable for use as a cover window of a flexible display device due to the excellent flexural properties and impact resistance thereof.

The polymer resin may be included in a film in various shapes and forms, such as a solid powder form, a form dissolved in a solution, a matrix form solidified after being dissolved in a solution, etc. Any resin containing the same repeating unit as the resin of the present disclosure may be considered the same as the polymer resin of the present disclosure, regardless of the shape and form thereof. In general, the polymer resin in the film may be present as a solidified matrix obtained by applying a polymer resin solution, followed by drying.

The polymer resin according to an embodiment of the present disclosure may be any light-transmitting resin. For example, the polymer resin may include at least one selected from cycloolefin-based derivatives, cellulose-based polymers, ethylene vinyl acetate-based copolymers, polyester-based polymers, polystyrene-based polymers, polyamide-based polymers, polyamide-imide-based polymers, polyetherimide-based polymers, polyacrylic-based polymers, polyimide-based polymers, polyether sulfone-based polymers, polysulfone-based polymers, polyethylene-based polymers, polypropylene-based polymers, polymethylpentene-based polymers, polyvinyl chloride-based polymers, polyvinylidene chloride-based polymers, polyvinyl alcohol-based polymers, polyvinyl acetal-based polymers, polyether ketone-based polymers, polyether ether ketone-based polymers, polymethyl methacrylate-based polymers, polyethylene terephthalate-based polymers, polybutylene terephthalate-based polymers, polyethylene naphthalate-based polymers, polycarbonate-based polymers, polyurethane-based polymers, and epoxy-based polymers. Preferably, the polymer resin according to an embodiment of the present disclosure may include at least one of polyimide-based polymers, polyamide-based polymers, and polyamide-imide-based polymers.

According to an embodiment of the present disclosure, the light-transmitting substrate 110 may be any one of polyimide substrates, polyamide substrates, and polyamide-imide substrates. However, the embodiments of the present disclosure are not limited thereto, and any substrate may be used as the light-transmitting substrate 110, as long as it is light-transmissive.

In one embodiment of the present disclosure, an optical film has a first impact resistance parameter calculated by the following Equation 1, of 0.08 or more:

[Equation 1]

First impact resistance parameter = [{(thickness of light-transmitting substrate x 1.5) + (restoration rate of light-transmitting substrate x 0.01 x 1.5) + (thickness of buffer layer x 2) + (restoration rate of buffer layer x 0.01 x 1.5)} x (restoration rate of optical film x 0.01 x 2) x puncture strength of optical film] / (thickness of optical film)$^2$

wherein the restoration rate (nIT; 12 mN) of the light-transmitting substrate 110, the buffer layer 120 and the optical film are measured under the conditions of 12 mN/12s/Creep 5s/24°C, 40RH% using a Nanoindentation tester (model HM2000 from Fischer Corporation). The measurement of the restoration rate (12 mN) is performed by orienting the buffer layer 120 downwards, orienting the light-transmitting substrate 110 upwards, and measuring the physical properties of the substrate as the upper layer. In Equation 1, the puncture strength of the optical film is measured using an S1-11855 model from Instron Corp. (probe size: 3.18 mm) in accordance with the ASTM D4830 standard.

In Equation 1, the basic unit of the thickness of the light-transmitting substrate, the thickness of the buffer layer, and the thickness of the optical film is um, the basic unit of the restoration rate (nIT; 12 mN) of the optical film is percentage (%), and the basic unit of the puncture strength of the optical film is kgf. In Equation 1, the unit is omitted and only numerical values are applied to calculate the first impact resistance parameter.

The optical film of the present disclosure has the first impact resistance parameter of 0.08 or more. The first impact resistance parameter is a parameter calculated using the thickness of the light-transmitting substrate, the thickness of the buffer layer, the thickness of the optical film, the restoration rate of the optical film, and the puncture strength. The first impact resistance parameter of 0.08 or more means that the optical film has excellent impact resistance in spite of a small thickness thereof.

More specifically, as the thickness of the light-transmitting substrate or the thickness of the buffer layer increases, the overall thickness of the optical film increases, and the first impact resistance parameter decreases. This means that, although the overall thickness of the optical film increases, impact resistance increases, but the bending characteristics of the optical film decrease, making it unsuitable for use as a cover window of a flexible display device. Therefore, in order to satisfy the first impact resistance parameter of 0.08 or more, the overall thickness of the optical film should be decreased based on the decrease in the thickness of the light-transmitting substrate and/or the thickness of the buffer layer, the restoration rate of the light-transmitting substrate and the buffer layer should be increased, and the restoration rate of the optical film and puncture strength should be increased.

That is, when the first impact resistance parameter of the optical film is 0.08 or more, the optical film can effectively protect the substrate inside the display device from external impact due to excellent durability thereof. As the thickness of the optical film decreases, bending characteristics are excellent. An optical film having a first impact resistance parameter of 0.08 or more is suitable for use as a cover window of a flexible display device. Conversely, the first impact resistance parameter less than 0.08 means that the optical film has a great thickness or poor durability, thus being unsuitable for use as a cover window of a flexible display device.

According to an embodiment of the present disclosure, the optical film includes the buffer layer 120 in order for the optical film to have a first impact resistance parameter of 0.08 or more. The buffer layer 120 may be formed on at least one of the two surfaces of the light-transmitting substrate 110. The buffer layer 120 may be formed on the upper surface of the light-transmitting substrate 110, may be formed on the lower surface thereof, or may be formed on both the upper surface and lower surface. The buffer layer 120 may be in direct contact with the light-transmitting substrate 110, or another layer may be disposed between the buffer layer 120 and the light-transmitting substrate 110.

According to an embodiment of the present disclosure, the buffer layer 120 may include a urethane acrylate resin.

According to an embodiment of the present disclosure, preferably, the buffer layer 120 may include a urethane acrylate siloxane resin.

In an embodiment of the present disclosure, the urethane acrylate siloxane resin may include a urethane acrylate silane compound represented by the following Formula 1, an alkoxysilane compound represented by the following Formula 2, and a diol compound represented by the following Formula 3:

[Formula 1]

$$(R^1O)_n - Si - (R^2 - NH - \overset{\overset{\displaystyle O}{\|}}{C} - O - R^3 - R^4)_{4-n}$$

wherein $R^1$ is a functional group derived from a C1-C8 aliphatic or aromatic hydrocarbon, $R^2$ and $R^3$ are each independently a C1-C6 linear, branched or alicyclic alkylene group, $R^4$ is an acrylate group or methacrylate group, and n is an integer of 1 to 3,

[Formula 2] $R^5{}_mSi(OR^6)_{4-m}$

wherein $R^5$ and $R^6$ are each independently a functional group derived from a C1-C8 aliphatic or aromatic hydrocarbon, and m is an integer of 0 to 3,

[Formula 3] $HO-R^7-OH$

wherein $R^7$ is a functional group derived from a C1-C6 aliphatic or aromatic hydrocarbon.

Since the buffer layer 120 according to the present disclosure includes the urethane acrylate siloxane resin prepared from a composition containing the compounds represented by Formulas 1 to 3, the optical film including the buffer layer 120 can achieve a first impact resistance parameter of 0.08 or more.

More specifically, since the urethane acrylate siloxane resin according to the present disclosure includes the urethane acrylate silane compound represented by Formula 1, the buffer layer 120 can achieve an improved restoration rate and serve to offset tensile or compressive forces applied to an inner substrate disposed in the lower part of the optical film when the display device is folded.

Since the urethane acrylate siloxane resin according to the present disclosure includes the alkoxysilane compound represented by Formula 2, the buffer layer 120 can achieve appropriate hardness and thus deformation of the optical film due to external force can be minimized.

Since the urethane acrylate siloxane resin according to the present disclosure includes the diol compound represented by Formula 3, the flexibility of the buffer layer 120 can be maximized, elasticity can be imparted to the buffer layer 120, and the smoothness of the coating surface can be improved when the light-transmitting substrate 110 is coated with the buffer layer 120. Therefore, when the optical film is folded, it is possible to prevent the buffer layer 120 from peeling off from the light-transmitting substrate 110 and thereby improve the folding reliability of the optical film.

According to an embodiment of the present disclosure, the composition for forming the urethane acrylate siloxane resin contains the urethane acrylate silane compound represented by Formula 1 and the alkoxysilane compound represented by Formula 2 at a molar ratio of 9:1 to 5:5. Preferably, the composition for forming the urethane acrylate siloxane resin may contain the urethane acrylate silane compound represented by Formula 1 and the alkoxysilane compound represented by Formula 2 at a molar ratio of 8:2 to 6:4.

When the molar ratio of the urethane acrylate silane compound represented by Formula 1 to the alkoxysilane compound represented by Formula 2 is higher than 9:1, in other words, when the molar amount of the urethane acrylate silane compound represented by Formula 1 is higher than the amount represented by the molar ratio of 9:1, for example, when the molar ratio is 10:0, that is, when the composition contains only the urethane acrylate silane compound represented by Formula 1, there are problems in that a buffer layer 120 that is not hard but soft is formed due to the greatly reduced hardness of the buffer layer 120 and restoration subsequent to external impact may be deteriorated. In addition, when the composition contains only the urethane acrylate silane compound represented by Formula 1, without the alkoxysilane compound represented by Formula 2, there is a problem in that the polymerization reaction is remarkably inhibited.

On the other hand, when the molar ratio of the urethane acrylate silane compound represented by Formula 1 to the alkoxysilane compound represented by Formula 2 is greater than 5:5, that is, when the molar amount of the alkoxysilane compound represented by Formula 2 is greater than the amount represented by the molar ratio of 5:5, there are problems in that the buffer layer 120 may be broken when used as a coating layer of a film due to the decreased flexibility and thus excessive hardness thereof, and the restoring force of the buffer layer 120 is lowered due to the low elasticity thereof.

Therefore, in order to impart appropriate hardness and elasticity to the buffer layer 120, the urethane acrylate silane compound represented by Formula 1 and the alkoxysilane compound represented by Formula 2 should be contained in a molar ratio of 9:1 to 5:5.

According to an embodiment of the present disclosure, the composition for forming the urethane acrylate siloxane resin may contain "the sum of the urethane acrylate silane compound represented by Formula 1 and the alkoxysilane compound represented by Formula 2" and the "diol compound represented by Formula 3" at a molar ratio of 8:2 to 3:7.

When the molar ratio of "the sum of the urethane acrylate silane compound represented by Formula 1 and the alkoxysilane compound represented by Formula 2" to the "diol compound represented by Formula 3" is greater than 8:2, there are problems in that the flexibility and elasticity of the buffer layer 120 may be lowered, and the buffer layer 120 may break or crack during folding. In addition, the smoothness of the coating surface of the buffer layer 120 may be reduced, and thus the buffer layer 120 may peel off of the light-transmitting substrate 110.

On the other hand, when the molar ratio of "the sum of the urethane acrylate silane compound represented by Formula 1 and the alkoxy silane compound represented by Formula 2" to the "diol compound represented by Formula 3" is less than 5:5, there are problems in that a soft buffer layer 120 having insufficient hardness is formed and restoration subsequent to external impact is reduced.

In an embodiment of the present disclosure, $R^4$ may be an acrylate group including a hydroxyl group (-OH). Specifically, for example, $R^4$ is an acrylate group derived from either 2-hydroxyethyl acrylate (2-HEA) or 4-hydroxybutyl acrylate (4-HBA).

According to an embodiment of the present disclosure, the urethane acrylate silane compound represented by Formula 1 may include at least one silane compound selected from a silane compound represented by the following Formula 4 and a silane compound represented by the following Formula 5:

[Formula 4]

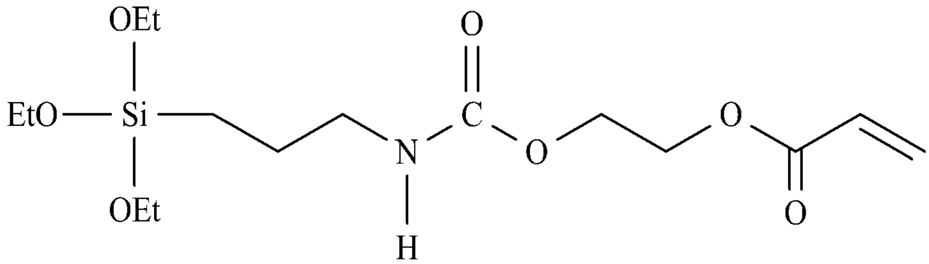

[Formula 5]

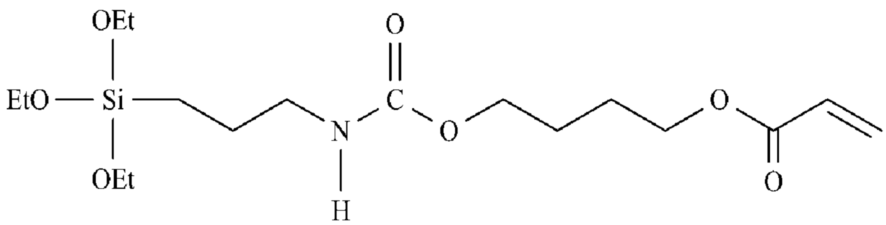

According to an embodiment of the present disclosure, the alkoxysilane compound represented by Formula 2 may include tetraalkoxysilane ($Si(OR^6)_4$). Since the composition for forming the urethane acrylate siloxane resin contains tetraalkoxysilane, the buffer layer 120 can be imparted with appropriate hardness and thus deformation of the optical film due to external force can be minimized. On the other hand, when trialkoxysilane or dialkoxysilane is contained therein, the improvement in the hardness of the buffer layer 120 is insufficient, so the extent of deformation of the optical film upon application of external force may increase.

According to an embodiment of the present disclosure, the diol compound represented by Formula 3 may include ethylene glycol. Since the composition for forming the urethane acrylate siloxane resin contains ethylene glycol, the buffer layer 120 can be imparted with increased flexibility and excellent elasticity.

According to one embodiment of the present disclosure, the light-transmitting substrate 110 may have a thickness of 10 to 100 um. When the thickness of the light-transmitting substrate 110 is less than 10 μm, the light-transmitting

substrate 110 is unsuitable for use as a cover window because the protective function of the display device against external force (impact or pressure) is lowered due to reduced impact resistance of the film. On the other hand, when the thickness of the light-transmitting substrate 110 is greater than 100 μm, the thickness of the optical film increases excessively, thus increasing the minimum radius of curvature during folding, deteriorating the bending characteristics of the optical film, decreasing visibility due to the decrease in light transmittance and obtaining the first impact resistance parameter less than 0.08.

According to an embodiment of the present disclosure, the buffer layer 120 may have a thickness of 10 to 150 um. When the thickness of the buffer layer 120 is less than 10 um, the effects of reducing the puncture strength of the optical film and the restoration rate are deteriorated and the first impact resistance parameter is less than 0.08. On the other hand, when the thickness of the buffer layer 120 is greater than 150 um, the thickness of the optical film excessively increases, the minimum radius of curvature during folding increases, and the bending characteristics of the optical film are deteriorated. Therefore, the optical film is not suitable for use as a cover window of a flexible display device. In addition, the surface hardness of the optical film is reduced, increasing the possibility of surface scratches.

The optical film according to an embodiment of the present disclosure may have a restoration rate (nIT) of 60 to 100% based on 12 mN. In addition, the optical film according to an embodiment of the present disclosure may have a restoration rate (nIT) of 50 to 100% based on 30 mN. The restoration rate (12 mN) of the optical film may be measured using a Nanoindentation tester (model HM2000 from Fischer Corporation) under conditions of 12 mN/12s/Creep 5s/24°C and 40RH%. The restoration rate (30 mN) of the optical film may be measured using a Nanoindentation tester (model HM2000 from Fischer Corporation) under conditions of 30 mN/12s/Creep 5s/24°C and 40RH%. The measurement of the restoration rate (12 mN) is performed by orienting the buffer layer 120 downwards, orienting the light-transmitting substrate 110 upwards, and measuring the physical properties of the substrate as the upper layer. The optical film of the present disclosure includes the buffer layer 120 and thus achieves a restoration rate (nIT; 12 mN) of 60% or more.

Hereinafter, other embodiments of the present disclosure will be described in detail with reference to FIGS. 3 to 5. FIGS. 3 to 5 are cross-sectional views illustrating an optical film according to other embodiments of the present disclosure, further including a hard coating layer.

According to another embodiment of the present disclosure, the optical film may further include the hard coating layer 130. As shown in FIG. 3, in the optical film of the present disclosure, the hard coating layer 130 may be formed on the upper surface of the light-transmitting substrate 110, but the present disclosure is not limited thereto. As shown in FIG. 4, the buffer layer 120 may be formed on the upper surface of the light-transmitting substrate 110, and the hard coating layer 130 may be formed on the upper surface of the buffer layer 120. In addition, as shown in FIG. 5, in the optical film according to the present disclosure, the buffer layer 120 may be formed on both the upper and lower surfaces of the light-transmitting substrate 110, and the hard coating layer 130 may be formed on the upper surface of the upper buffer layer 120. The buffer layer 120 and the hard coating layer 130 may be disposed in any number at any position as needed, and another layer may also be formed between the light-transmitting substrate 110 and the buffer layer 120, or between the light-transmitting substrate 110 and the hard coating layer 130, or between the buffer layer 120 and the hard coating layer 130.

Since the optical film of the present disclosure further includes the hard coating layer 130, mechanical properties such as durability and scratch resistance of the optical film can be improved.

According to another embodiment of the present disclosure, the hard coating layer 130 may include at least one of an epoxy resin, a siloxane resin, and an acrylate resin.

In another embodiment of the present disclosure, the optical film may further include a hard coating layer, wherein the optical film has a second impact resistance parameter calculated by the following Equation 2, of 0.08 or more:

[Equation 2]

Second impact resistance parameter = [{(thickness of light-transmitting substrate x 1.5) + (restoration rate of light-transmitting substrate x 1.5 x 0.01) + (thickness of buffer layer x 2) + (restoration rate of buffer layer x 1.5 x 0.01)} + (thickness of hard coating layer X 1) + (restoration rate of hard coating layer x 0.01 x 1)} x (restoration rate of optical film x 0.01 x 2) x puncture strength of optical film] / (thickness of optical film)$^2$

wherein the restoration rate (nIT; 12 mN) of the light-transmitting substrate, the buffer layer, the hard coating layer and the optical film are measured under the conditions of 12 mN/12s/Creep 5s/24°C, 40RH% using a Nanoindentation tester (model HM2000 from Fischer Corporation). The measurement of the restoration rate (nIT; 12 mN) is performed by orienting the buffer layer 120 downwards, orienting the light-transmitting substrate 110 upwards, and measuring the physical properties of the substrate as the upper layer. In Equation 2, the puncture strength of the optical film is measured using model S1-11855 from Instron Corp. (probe size: 3.18 mm) in accordance with the ASTM D4830 standard.

The basic unit in Equation 2 is the same as that in Equation 1 described above, and the restoration rates (nIT; 12 mN) of the light-transmitting substrate, the buffer layer, the hard coating layer and the optical film, and the puncture strength of the optical film of Equation 2 are the same as those of Equation 1. Therefore, detailed descriptions thereof will be omitted in order to avoid duplication.

According to another embodiment of the present disclosure, the hard coating layer 130 may have a thickness of 0.1 to 10 um. When the thickness of the hard coating layer 130 is less than 0.1 um, the improvement in durability and scratch resistance due to the hard coating layer 130 may be insufficient. On the other hand, when the thickness of the hard coating layer 130 is greater than 10 μm, it is difficult to use the optical film as a cover window of the flexible display device due to the increased drag force of the optical film. When the flexible display device is folded/rolled, the possibility of cracking of the hard coating layer increases, and the second impact resistance parameter may be less than 0.08.

According to an embodiment of the present disclosure, the optical film is light-transmissive. In addition, the optical film is flexible. For example, the optical film may be bendable, foldable and rollable. The optical film may have superior mechanical and optical properties.

According to an embodiment of the present disclosure, the optical film may have a thickness sufficient for the optical film to protect the display panel. For example, the optical film may have a thickness of 20 to 300 μm.

The optical film according to an embodiment of the present disclosure may have a yellow index of 5.0 or less based on a thickness of 100 um. In addition, the optical film according to an embodiment of the present disclosure may have a yellow index of 4.0 or less, or a yellow index of 2.0 or less, based on a thickness of 80 μm.

The yellow index may be measured using a CM-3700 spectrophotometer produced by KONICA MINOLTA under conditions of D65, 2° and transmittance.

The optical film according to an embodiment of the present disclosure may have light transmittance of 88.00% or more in a visible light region measured with a UV spectrophotometer, based on a thickness of 100 um. In addition, the optical film according to an embodiment of the present disclosure may have light transmittance of 90% or more or light transmittance of 91% or more based on a thickness of 100 μm.

The light transmittance may be measured in a wavelength range of 360 to 740 nm using a spectrophotometer in accordance with the JIS K 7361 standard. An example of the spectrophotometer used herein may be an HM-150 haze meter produced by Murakami Color Research Laboratory.

The optical film according to an embodiment of the present disclosure may have a haze of 2.0 or less based on a thickness of 100 um. In addition, the optical film according to an embodiment of the present disclosure may have a haze of 1.0 or less, or a haze of 0.5 or less, based on a thickness of 100 μm.

The haze may be measured with a spectrophotometer in accordance with the JIS K 7136 standard. An example of the spectrophotometer used herein may be an HM-150 haze meter produced by Murakami Color Research Laboratory.

The optical film according to an embodiment of the present disclosure may have a reflectance (5°) of 3.9 to 7.0 with respect to light having a wavelength of 550 nm based on a thickness of 100 μm.

The reflectance (5°) may be measured under conditions of 350-800 nm, 5° and a reflective mode using a UH4150 spectrophotometer (UV-vis) produced by HITACHI.

The optical film according to an embodiment of the present disclosure may have a tensile strength of 70 to 180 MPa based on a thickness of 100 μm.

The tensile strength of a sample film (50 mm X 10 mm) obtained from an optical film may be measured under the conditions of 25°C/50RH% and 25 mm/min using a universal tester (INSTRON) in accordance with the ASTM D882 standard.

The optical film according to an embodiment of the present disclosure may have an elongation of 15 to 35% based on a thickness of 100 μm.

The elongation of a sample film (50mm X 10mm) obtained from an optical film may be measured at 25°C/50 RH% and 25 mm/min using a universal tester (INSTRON) in accordance with the ASTM D882 standard.

Hereinafter, a display device using an optical film according to an embodiment of the present disclosure will be described with reference to FIGS. 6 and 7.

FIG. 6 is a cross-sectional view illustrating a part of a display device 200 according to another embodiment, and FIG. 6 is an enlarged cross-sectional view of part "P" in FIG. 6.

Referring to FIG. 6, the display device 200 according to another embodiment of the present disclosure includes a display panel 501 and an optical film 100 on the display panel 501.

Referring to FIGS. 6 and 7, the display panel 501 includes a substrate 510, a thin film transistor TFT on the substrate 510, and an organic light-emitting device 570 connected to the thin film transistor TFT. The organic light-emitting device 570 includes a first electrode 571, an organic light-emitting layer 572 on the first electrode 571, and a second electrode 573 on the organic light-emitting layer 572. The display device 200 shown in FIGS. 6 and 7 is an organic light-emitting display device.

The substrate 510 may be formed of glass or plastic. Specifically, the substrate 510 may be formed of plastic such as a polymer resin or an optical film. Although not shown, a buffer layer may be disposed on the substrate 510.

The thin film transistor TFT is disposed on the substrate 510. The thin film transistor TFT includes a semiconductor layer 520, a gate electrode 530 that is insulated from the semiconductor layer 520 and overlaps at least a part of the semiconductor layer 520, a source electrode 541 connected to the semiconductor layer 520, and a drain electrode 542 that is spaced apart from the source electrode 541 and is connected to the semiconductor layer 520.

Referring to FIG. 7, a gate insulating layer 535 is disposed between the gate electrode 530 and the semiconductor layer 520. An interlayer insulating layer 551 may be disposed on the gate electrode 530, and a source electrode 541 and a drain electrode 542 may be disposed on the interlayer insulating layer 551.

A planarization layer 552 is disposed on the thin film transistor TFT to planarize the top of the thin film transistor TFT.

The first electrode 571 is disposed on the planarization layer 552. The first electrode 571 is connected to the thin film transistor TFT through a contact hole provided in the planarization layer 552.

A bank layer 580 is disposed on the planarization layer 552 in a part of the first electrode 571 to define pixel areas or light-emitting areas. For example, the bank layer 580 is disposed in the form of a matrix at the boundaries between a plurality of pixels to define the respective pixel regions.

The organic light-emitting layer 572 is disposed on the first electrode 571. The organic light-emitting layer 572 may also be disposed on the bank layer 580. The organic light-emitting layer 572 may include one light-emitting layer or two light-emitting layers stacked in a vertical direction. Light having any one color among red, green, and blue may be emitted from the organic light-emitting layer 572, and white light may be emitted therefrom.

The second electrode 573 is disposed on the organic light-emitting layer 572.

The first electrode 571, the organic light-emitting layer 572, and the second electrode 573 may be stacked to constitute the organic light-emitting device 570.

Although not shown, when the organic light-emitting layer 572 emits white light, each pixel may include a color filter for filtering the white light emitted from the organic light-emitting layer 572 based on a particular wavelength. The color filter is formed in the light path.

A thin film encapsulation layer 590 may be disposed on the second electrode 573. The thin film encapsulation layer 590 may include at least one organic layer and at least one inorganic layer, and the at least one organic layer and the at least one inorganic layer may be alternately disposed.

The optical film 100 according to the present disclosure is disposed on the display panel 501 having the stack structure described above.

Hereinafter, the present disclosure will be described in more detail with reference to exemplary Preparation Examples, Examples, and Comparative Examples. However, these Preparation Examples, Examples, and Comparative Examples should not be construed as limiting the scope of the present disclosure.

<Preparation Example 1: Preparation of polymer resin composition for light-transmitting substrate>

80.06 g (250 mmol) of TFDB (diamine-based compound) was dissolved in dimethylacetamide (DMAc, solvent) in a 4-neck double-jacketed reactor. 19.86 g (68 mmol) of BPDA (dianhydride compound) was added thereto and stirred while the temperature of the reactor was maintained at 25°C for 2 hours. Upon completion of the reaction, 13.33 g (30 mmol) of 6FDA (dianhydride compound) was added thereto, followed by stirring at 25°C for 1 hour. Then, 29.945 g (154 mmol) of TPC was added to the reaction solution, followed by stirring at 15°C for 1 hour.

After the polymerization reaction was completed, pyridine (Py, 16.97 g) as an imidization catalyst and acetic anhydride (AA, 21.97 g) as a dehydrating agent were added to the reaction solution, the temperature was increased to 80°C, and the reaction solution was stirred for 1 hour. The reaction solution was cooled to room temperature and poured into methanol (3,000 ml) to cause precipitation. The precipitate was filtered to obtain a polymer resin as a white solid. The obtained polymer resin was in the form of a solid powder. The polymer resin prepared in Preparation Example 1 was a polyamide-imide polymer resin.

The polymer resin obtained as the solid powder was dissolved in dimethylacetamide (DMAc) at a concentration of 12.7 wt% to prepare a polymer resin composition.

<Preparation Example 2: Preparation of urethane acrylate siloxane resin composition for buffer layer>

1) 495 g (2.00 mol) of a compound (3-(triethoxysilyl) propyl isocyanate, Shinetsu, KBE-9007) represented by the following Formula 6, 317 g (2.20 mol) of 4-hydroxybutyl acrylate (OSAKA Organic Chemical Industry, 4-HBA), and 11 g of triethylamine were put into a 500 mL glass reactor and allowed to react with stirring for 24 hours at room temperature using a mechanical stirrer.

[Formula 6]

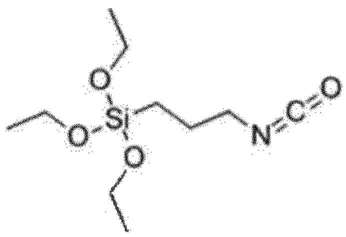

2) 353 g (0.70 mmol) of the reaction product obtained in step 1), 62 g (0.30 mol) of tetraethoxysilane (EVONIK, Dynasylan A), 9 g of $H_2O$, 72 g (1.16 mol) of ethylene glycol (Sigma-Aldrich), and 0.1 g of NaOH were put into a 500 mL glass reactor and allowed to react with stirring at 80°C for 8 hours using a mechanical stirrer.

3) A urethane acrylate siloxane resin composition represented by Formula 5 was obtained.

<Preparation Example 3: Preparation of resin composition for hard coating layer>

1) 223 g (0.09 mol) of 3-methacryloxypropyl triethoxysilane (Shinetsu, KBM-503), 21 g (0.10 mol) of tetraethoxysilane (EVONIK, Dynasylan A), 28 g of $H_2O$, and 0.1 g of NaOH were put into a 500 mL glass reactor and allowed to react with stirring at 80°C for 8 hours using a mechanical stirrer to obtain a siloxane resin composition.

The weight average molecular weight of the acrylate siloxane resin, measured using GPC, was 6,736, and the PDI thereof was 2.6.

<Example 1>

1) The polymer resin composition solution prepared in Preparation Example 1 was cast. A casting substrate was

used for casting. There is no particular limitation as to the type of the casting substrate. The casting substrate may be a glass substrate, a stainless steel (SUS) substrate, a Teflon substrate, or the like. According to an embodiment of the present disclosure, the casting substrate may be, for example, a glass substrate.

Specifically, the polymer resin solution of Preparation Example 1 was applied to a glass substrate, cast, and dried with hot air at 80°C for 20 minutes and at 120°C for 20 minutes to produce a light-transmitting substrate, and then the produced light-transmitting substrate was peeled off of the glass substrate and fixed to the frame with a pin.

The frame to which the light-transmitting substrate was fixed was placed in an oven and dried with hot air at a constant temperature of 290°C for 30 minutes. As a result, a light-transmitting substrate having a thickness of 50 um was obtained.

2) 10 g of the urethane acrylate siloxane resin composition of Preparation Example 2, 10 g of 2-butanone (MEK), and 0.1 g of IRGACURE 184 were mixed, and the resulting mixture was applied to the light-transmitting substrate produced in 1) using a Mayer bar or an applicator to form a coating film.

The light-transmitting substrate coated with the urethane acrylate siloxane resin composition was cured in an oven at 150°C for 25 minutes to produce an optical film coated with a buffer layer. The thickness of the buffer layer was 15 um. In this case, the buffer layer was the lower layer of the optical film and the light-transmitting substrate was the upper layer of the optical film.

<Examples 2 to 8>

The optical films of Examples 2 to 8 were produced in the same manner as in Example 1, except that only the thickness of the light-transmitting substrate and the thickness of the buffer layer were changed.

The details of the thicknesses of the light-transmitting substrates and thicknesses of the buffer layers with respect to Examples 2 to 8 are shown in Table 1 below.

<Example 9>

1) An optical film was produced in the same manner as in Example 2 above.

2) 10g of the resin composition for the hard coating layer of Preparation Example 3, 10 g of 2-butanone (MEK), and 0.1 g of 1-benzoylcyclohexanol (IRGACURE 184 from BASF) were mixed, and the resulting mixture was applied to the optical film produced in 1) using a Mayer bar or an applicator to form a coating film.

3) The optical film coated with the resin composition for the hard coating layer was dried in an oven at 100°C for 10 minutes and exposed to UV (150 mW/cm$^2$, 2 J/cm$^2$) to produce an optical film coated with the hard coating layer. The thickness of the hard coating layer was 5 μm.

<Examples 10 to 12>

Optical films according to Examples 10 to 12 were produced in the same manner as in Example 9, except that only the thickness of the buffer layer was changed.

The details of the thicknesses of the buffer layers of Examples 10 to 12 are shown in Table 1 below.

In this case, in Examples 10 and 11, the hard coating layer was laminated on the light-transmitting substrate and in Example 12, the hard coating layer was laminated on the buffer layer.

<Example 13>

1) A light-transmitting glass substrate having a thickness of 50 um was prepared as the light-transmitting substrate.

2) 10 g of the urethane acrylate resin composition of Preparation Example 2, 10 g of 2-butanone (MEK), and 0.1 g of IRGACURE 184 were mixed, and the resulting mixture was applied to the light-transmitting glass substrate using a Mayer bar or an applicator to form a coating film.

The light-transmitting substrate coated with the urethane acrylate siloxane resin composition was dried in an oven at 150°C for 25 minutes to produce an optical film coated with the buffer layer. The thickness of the buffer layer was 150 um. In this case, the buffer layer was the lower layer of the optical film and the light-transmitting substrate was the upper layer of the optical film.

3) 10 g of the resin composition for the hard coating layer of Preparation Example 3, 10 g of 2-butanone (MEK),

and 0.1 g of 1-benzoylcyclohexanol (IRGACURE 184 from BASF) were mixed, and the resulting mixture was applied to the optical film produced in 3) using a Mayer bar or an applicator to form a coating film.
4) The optical film coated with the resin composition for the hard coating layer was dried in an oven at 100°C for 10 minutes and exposed to UV (150 $mW/cm^2$, 2 $J/cm^2$) to produce an optical film including the hard coating layer. The thickness of the hard coating layer was 5 $\mu$m.

<Comparative Example 1>

1) The polymer resin composition solution prepared in Preparation Example 1 was cast. A casting substrate was used for casting. There is no particular limitation as to the type of the casting substrate. The casting substrate may be a glass substrate, a stainless steel (SUS) substrate, a Teflon substrate, or the like. According to an embodiment of the present disclosure, the casting substrate may be, for example, a glass substrate.

Specifically, the polymer resin solution of Preparation Example 1 was applied to a glass substrate, cast, and dried with hot air at 80°C for 20 minutes and at 120°C for 20 minutes to produce a light-transmitting substrate, and then the produced light-transmitting substrate was peeled off of the glass substrate and fixed to the frame with a pin.
The frame to which the light-transmitting substrate was fixed was placed in an oven and dried with hot air at a constant temperature of 290°C for 30 minutes. As a result, a light-transmitting substrate having a thickness of 50 um was obtained.
Comparative Example 1 is an optical film including only the light-transmitting substrate.

<Comparative Example 2>

1) An optical film of Comparative Example 2 was produced in the same manner as in Example 1, except that only the thickness of the light-transmitting substrate and the thickness of the buffer layer were changed.

Details of the thickness of the light-transmitting substrate and the thickness of the buffer layer of Comparative Example 2 are shown in Table 1 below.

<Comparative Examples 3 to 6>

1) A light-transmitting substrate was produced in the same manner as in Comparative Example 1.
2) in Comparative Examples 3 to 6, the hard coating layer was formed on the light-transmitting substrate produced in 1) by changing only the thickness of the hard coating layer. Specifically, 10 g of the resin composition for hard coating layer of Preparation Example 3, 10 g of 2-butanone (MEK), and 0.1 g of 1-benzoylcyclohexanol (IRGACURE 184 produced by BASF) were mixed, and the resulting mixture was applied to the light-transmitting substrate produced in 1) using a Mayer bar or an applicator to form a coating film.

The optical film coated with the resin composition for the hard coating layer was dried in an oven at 100°C for 10 minutes to produce an optical film including the hard coating layer.
The details of the thicknesses of the hart coating layers according to Comparative Examples 3 to 6 are shown in Table 1 below.

[Table 1]

| Item | Thicknes s of light-transmit ting substrat e (pm) | Thickne ss of buffer layer (pm) | Thickness of hard coating layer (pm) | Thickne ss of optical film (pm) | Stack order |
|---|---|---|---|---|---|
| Example 1 | 50 | 15 | - | 65 | Buffer layer/subst rate |

(continued)

| Item | Thicknes s of light-transmit ting substrat e (pm) | Thickne ss of buffer layer (pm) | Thickness of hard coating layer (pm) | Thickne ss of optical film (pm) | Stack order |
|---|---|---|---|---|---|
| Example 2 | 50 | 30 | - | 80 | Buffer layer/subst rate |
| Example 3 | 50 | 50 | - | 100 | Buffer layer/subst rate |
| Example 4 | 50 | 100 | - | 150 | Buffer layer/subst rate |
| Example 5 | 50 | 10 | - | 60 | Buffer layer/subst rate |
| Example 6 | 50 | 150 | - | 200 | Buffer layer/subst rate |
| Example 7 | 80 | 30 | - | 110 | Buffer layer/subst rate |
| Example 8 | 80 | 100 | - | 180 | Buffer layer/subst rate |
| Example 9 | 50 | 30 | 5 | 85 | Buffer layer/subst rate/hard coating |
| Example 10 | 50 | 50 | 5 | 105 | Buffer layer/subst rate/hard coating |
| Example 11 | 50 | 100 | 5 | 155 | Buffer layer/subst rate/hard coating |
| Example 12 | 50 | 15 | 5 | 70 | Substrate/B uffer layer/hard coating |
| Example 13 | 50 | 150 | 5 | 205 | Buffer layer/subst rate/hard coating |
| Comparat ive Example 1 | 50 | - | - | 50 | Substrate |
| Comparat ive Example 2 | 50 | 5 | - | 55 | Buffer layer/subst rate |
| Comparat ive Example 3 | 50 | - | 5 | 55 | Substrate/h ard coating layer |
| Comparat ive Example 4 | 50 | - | 10 | 60 | Substrate/h ard coating layer |
| Comparat ive Example 5 | 50 | - | 150 | 200 | Substrate/h ard coating layer |
| Comparat ive Example 6 | 50 | - | 155 | 205 | Substrate/h ard coating layer |

<Measurement Example>

The following measurements were performed on the polymer resins and films prepared in Examples 1 to 12 and Comparative Examples 1 to 6. However, Comparative Examples 5 and 6 relate to optical films that include a hard coating layer having a thickness of 150 um or more, and are unfoldable. Therefore, Comparative Examples 5 and 6 were excluded from the measurement of the following physical properties.

1) Puncture strength (kgf): The puncture strength is measured in accordance with the standard ASTM D4830.
2) 12 mN and 30 mN restoration rates (nIT, %): the restoration rates (nIT; 12 mN) of the light-transmitting substrate, the buffer layer, the hard coating layer and the optical film are measured under the conditions of 12 mN/12s/Creep 5s/24°C, 40RH% using a Nanoindentation tester (model HM2000 from Fischer Corporation), and the restoration rates (30 mN) thereof are measured using a Nanoindentation tester (Fischer Corporation, model HM2000) under conditions of 30 mN/12s/Creep 5s/24°C and 40 RH%. The measurement of the restoration rate (12 mN) is performed by orienting the buffer layer 120 downwards, orienting the light-transmitting substrate 110 upwards, and measuring the physical properties of the substrate as the upper layer.
3) Impact resistance parameter: the impact resistance parameter of the optical film was calculated in accordance with the following Equation 1 or 2 below.

[Equation 1]

First impact resistance parameter = [{(thickness of light-transmitting substrate x 1.5) + (restoration rate of light-transmitting substrate x 0.01 x 1.5) + (thickness of buffer layer x 2) + (restoration rate of buffer layer x 0.01 x 1.5)} x (restoration rate of optical film x 0.01 x 2) x puncture strength of optical film] / (thickness of optical film)$^2$

[Equation 2]

Second impact resistance parameter = [{(thickness of light-transmitting substrate x 1.5) + (restoration rate of light-transmitting substrate x 1.5 x 0.01) + (thickness of buffer layer x 2) + (restoration rate of buffer layer x 1.5 x 0.01)} + (thickness of hard coating layer X 1) + (restoration rate of hard coating layer x 0.01 x 1)} x (restoration rate of optical film x 0.01 x 2) x puncture strength of optical film] / (thickness of optical film)$^2$

4) Yellow index (Y.I.): the yellow index is measured using a CM-3700 spectrophotometer produced by KONICA MINOLTA under conditions of D65, 2° and transmittance.
5) Light transmittance (%): Light transmittance (%) was measured in a wavelength range of 360 to 740 nm using a spectrophotometer in accordance with the JIS K 7361 standard. The spectrophotometer used herein was an HM-150 haze meter produced by Murakami Color Research Laboratory.
6) Haze: haze was measured using a spectrophotometer in accordance with the JIS K 7136 standard. The spectrophotometer used herein was an HM-150 haze meter produced by Murakami Color Research Laboratory.
7) Reflectance (5°): reflectance was measured under conditions of 350-800 nm, 5° and a reflective mode using a spectrophotometer UH4150 (UV-vis) produced by HITACHI.
8) Tensile strength (Mpa): the tensile strength of a sample film (50 mm X 10 mm) obtained from an optical film was measured under the conditions of 25°C/50RH% and 25 mm/min using a universal tester (INSTRON) in accordance with standard ASTM D882.
9) Elongation (%): the elongation of a sample film (50 mm X 10 mm) obtained from an optical film was measured at 25°C/50 RH% and 25 mm/min in accordance with the standard ASTM D882 using a universal tester (INSTRON).
10) Puncture test: display devices were manufactured using the optical films of Examples and Comparative Examples, and a puncture test was performed using the display devices. The puncture test was performed in accordance with the standard ASTM D4830 by determining whether or not dark spots N.G. were generated in the display device, when a load of 4 kgf was applied to the center of the display device at a constant speed (5 mm/min).

The measurement results are shown in Tables 2 and 3 below.

[Table 2]

| Item | Restoration rate of optical film (nIT, %) | | Restorati on rate of light-transmitt ing substrate (nIT, %) | Restora tion rate of bufferlayer (nIT, % ) | Restorat ion rate of hard coating layer (nIT, %) | Puncture strength (kgf) | Impact resista nce paramet er |
|---|---|---|---|---|---|---|---|
| | 12 mN | 30 mN | | | | | |
| Example 1 | 69 | 65 | 63 | 43 | 0 | 3.2 | 0.1114 |
| Example 2 | 72 | 68 | 63 | 49 | 0 | 4.2 | 0.1292 |
| Example 3 | 76 | 74 | 63 | 55 | 0 | 4.6 | 0.1236 |
| Example 4 | 87 | 86 | 63 | 77 | 0 | 6.3 | 0.1350 |
| Example 5 | 63 | 60 | 63 | 40 | 0 | 2.4 | 0.0811 |
| Example 6 | 94 | 94 | 63 | 96 | 0 | 7.0 | 0.1242 |
| Example 7 | 74 | 73 | 68 | 48 | 0 | 4.7 | 0.1045 |
| Example 8 | 82 | 79 | 68 | 75 | 0 | 7.3 | 0.1190 |
| Example 9 | 74 | 76 | 63 | 49 | 68 | 4.0 | 0.1166 |
| Example 10 | 83 | 88 | 63 | 55 | 68 | 4.8 | 0.1319 |
| Example 11 | 100 | 100 | 63 | 77 | 68 | 6.3 | 0.1483 |
| Example 12 | 90 | 92 | 63 | 43 | 68 | 3.6 | 0.1485 |
| Example 13 | 100 | 100 | 100 | 96 | 68 | 9.0 | 0.1643 |
| Comparat ive Example 1 | 65 | 63 | 63 | 0 | 0 | 2.0 | 0.0790 |
| Comparat ive Example 2 | 60 | 52 | 63 | 39 | 0 | 2.1 | 0.0721 |
| Comparat ive Example 3 | 68 | 73 | 63 | 0 | 68 | 2.1 | 0.0771 |

(continued)

| Item | Restoration rate of optical film (nIT, %) | | Restoration rate of light-transmitting substrate (nIT, %) | Restoration rate of bufferlayer (nIT, % ) | Restoration rate of hard coating layer (nIT, %) | Puncture strength (kgf) | Impact resistance parameter |
|---|---|---|---|---|---|---|---|
| | 12 mN | 30 mN | | | | | |
| Comparative Example 4 | 69 | 74 | 63 | 0 | 69 | 2.3 | 0.0764 |
| Comparative Example 5 | Excluded from measurement | Excluded from measurement | Excluded from measurement | Excluded from measurement | Excluded from measurement | Excluded from measurement | Excluded from measurement |
| Comparative Example 6 | Excluded from measurement | Excluded from measurement | Excluded from measurement | Excluded from measurement | Excluded from measurement | Excluded from measurement | Excluded from measurement |

[Table 3]

| Item | Yellow index (Y.I.) | Light transmittance (%) | Haze | Reflectance (5°) | Tensile strength (MPa) | Elongation (%) | Whether or not black spots N.G. are generated after puncture test |
|---|---|---|---|---|---|---|---|
| Example 1 | 2.8 | 90.0 | 0.3 | 6.29 | 155 | 19 | X |
| Example 2 | 2.7 | 90.1 | 0.5 | 6.21 | 147 | 20 | X |
| Example 3 | 2.6 | 90.1 | 0.3 | 6.14 | 132 | 25 | X |
| Example 4 | 2.9 | 90.0 | 0.4 | 4.30 | 106 | 30 | X |
| Example 5 | 2.6 | 90.0 | 0.3 | 6.36 | 161 | 19 | X |
| Example 6 | 2.7 | 90.3 | 0.3 | 3.90 | 78 | 32 | X |
| Example 7 | 3.9 | 89.8 | 0.4 | 6.33 | 178 | 24 | X |
| Example 8 | 3.8 | 89.9 | 0.3 | 6.32 | 135 | 33 | X |
| Example 9 | 2.7 | 90.5 | 0.4 | 4.54 | 132 | 18 | X |
| Example 10 | 2.6 | 90.3 | 0.4 | 4.53 | 98 | 17 | X |
| Example 11 | 2.8 | 90.6 | 0.5 | 4.24 | 77 | 17 | X |
| Example 12 | 2.8 | 90.2 | 0.5 | 5.80 | 130 | 20 | X |

(continued)

| Item | Yellow index (Y.I.) | Light transmittanc e (%) | Haze | Reflectance (5°) | Tensile strength (MPa) | Elongation (%) | Whether or not black spots N.G. are generated after puncture test |
|---|---|---|---|---|---|---|---|
| Example 13 | 0.4 | 91.3 | 0.2 | 5.40 | 700 | 0.5 | X |
| Comparative Example 1 | 2.9 | 89.4 | 0.3 | 6.18 | 281 | 29 | ○ |
| Comparative Example 2 | 2.8 | 89.9 | 0.3 | 6.40 | 159 | 18 | ○ |
| Comparative Example 3 | 2.9 | 89.6 | 0.5 | 4.52 | 199 | 18 | ○ |
| Comparative Example 4 | 2.9 | 89.7 | 0.3 | 4.48 | 162 | 17 | ○ |
| Comparative Example 5 | Excluded from measurement | Excluded from measurement | Excluded from measurement | Excluded from measurement | Excluded from measurement | Excluded from measurement | ○ |
| Comparative Example 6 | Excluded from measurement | Excluded from measurement | Excluded from measurement | Excluded from measurement | Excluded from measurement | Excluded from measurement | ○ |

As can be seen from the measurement results shown in Tables 2 and 3, all of the optical films of Examples 1 to 13 of the present disclosure had an impact resistance parameter of 0.08 or more and caused no generation of black spots N.G. after the puncture test.

However, among the optical films of Comparative Examples 1 to 6, the optical films of Comparative Examples 5 and 6 were too hard to be folded, and the optical films of Comparative Examples 1 to 4 had folding trace parameters of less than 0.08, and caused generation of black spots N.G. after the puncture test.

[Explanation of reference numerals]

100: Optical film
110: Light-transmitting substrate
120: Buffer layer
130: Hard coating layer
200: Display device
501: Display panel

## Claims

1. An optical film comprising:

   a light-transmitting substrate; and
   a buffer layer,
   the optical film having a first impact resistance parameter calculated by the following Equation 1, of 0.08 or more:

[Equation 1]

First impact resistance parameter = [{(thickness of light-transmitting substrate x 1.5) + (restoration rate of light-transmitting substrate x 0.01 x 1.5) + (thickness of buffer layer x 2) + (restoration rate of buffer layer x 0.01 x 1.5)} x (restoration rate of optical film x 0.01 x 2) x puncture strength of optical film] / (thickness of optical film)$^2$

   wherein the restoration rate (nIT; 12 mN) of the light-transmitting substrate, the buffer layer and the optical film are measured under the conditions of 12 mN/12s/Creep 5s/24°C, 40 RH% using HM2000 produced by Fischer Corporation, and the puncture strength is measured in accordance with the ASTM D4830 standard.

2. The optical film according to claim 1, wherein the buffer layer comprises a urethane acrylate resin.

3. The optical film according to claim 1, wherein the buffer layer comprises a urethane acrylate siloxane resin.

4. The optical film according to claim 3, wherein the urethane acrylate siloxane resin comprises:

   a urethane acrylate silane compound represented by the following Formula 1;
   an alkoxysilane compound represented by the following Formula 2; and
   a diol compound represented by the following Formula 3:

[Formula 1]

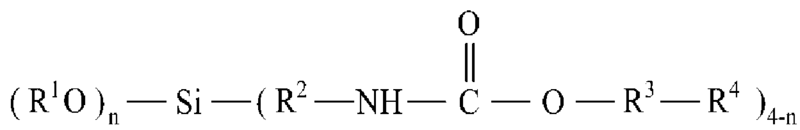

   wherein $R^1$ is a functional group derived from a C1-C8 aliphatic or aromatic hydrocarbon, $R^2$ and $R^3$ are each independently a C1-C6 linear, branched, or alicyclic alkylene group, $R^4$ is an acrylate group or methacrylate group, and n is an integer of 1 to 3,

[Formula 2] $R^5_mSi(OR^6)_{4-m}$

   wherein $R^5$ and $R^6$ are each independently a functional group derived from a C1-C8 aliphatic or aromatic hydrocarbon, and m is an integer of 0 to 3,

[Formula 3] $HO-R^7-OH$

   wherein $R^7$ is a functional group derived from a C1-C6 aliphatic or aromatic hydrocarbon.

**5.** The optical film according to claim 4, wherein $R^4$ is an acrylate group including a hydroxyl group (-OH).

**6.** The optical film according to claim 4, wherein $R^4$ is an acrylate group derived from one of 2-hydroxyethyl acrylate (2-HEA) and 4-hydroxybutyl acrylate (4-HBA).

**7.** The optical film according to claim 4, wherein the alkoxysilane compound comprises tetraalkoxysilane.

**8.** The optical film according to claim 4, wherein the diol compound comprises ethylene glycol.

**9.** The optical film according to claim 1, wherein the buffer layer has a thickness of 10 to 150 um.

**10.** The optical film according to claim 1, wherein the light-transmitting substrate has a thickness of 10 to 100 um.

**11.** The optical film according to claim 1, wherein the optical film has a restoration rate (nIT) of 60 to 100% based on 12 mN.

**12.** The optical film according to claim 1, further comprising a hard coating layer,

wherein the optical film has a second impact resistance parameter calculated by the following Equation 2, of 0.08 or more:

[Equation 2]

Second impact resistance parameter = [{(thickness of light-transmitting substrate x 1.5) + (restoration rate of light-transmitting substrate x 1.5 x 0.01) + (thickness of buffer layer x 2) + (restoration rate of buffer layer x 1.5 x 0.01)} + (thickness of hard coating layer X 1) + (restoration rate of hard coating layer x 0.01 x 1)} x (restoration rate of optical film x 0.01 x 2) x puncture strength of optical film] / (thickness of optical film)$^2$

wherein the restoration rates (nIT; 12 mN) of the light-transmitting substrate, the buffer layer, the hard coating layer and the optical film are measured under the conditions of 12 mN/12s/Creep 5s/24°C, 40RH% using HM2000 produced by Fischer Corporation, and the puncture strength is measured in accordance with the ASTM D4830 standard.

**13.** The optical film according to claim 12, wherein the hard coating layer has a thickness of 0.1 to 10 um.

**14.** A display device comprising:

a display panel; and
the optical film according to any one of claims 1 to 13, disposed on the display panel.

FIG. 1

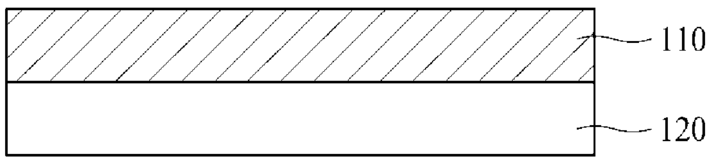

FIG. 2

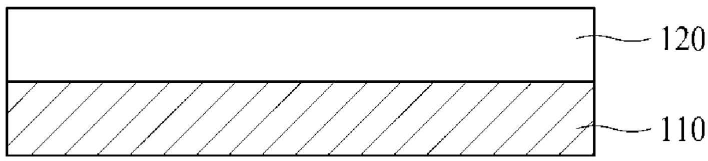

FIG. 3

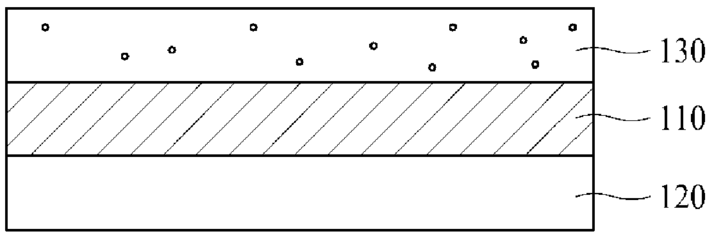

FIG. 4

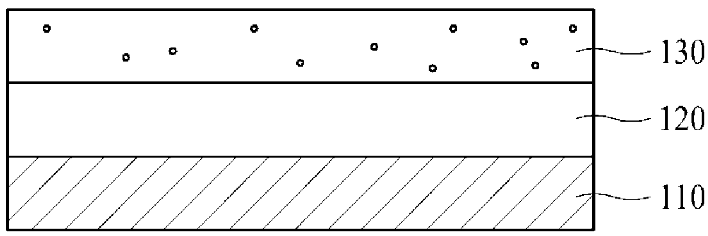

FIG. 5

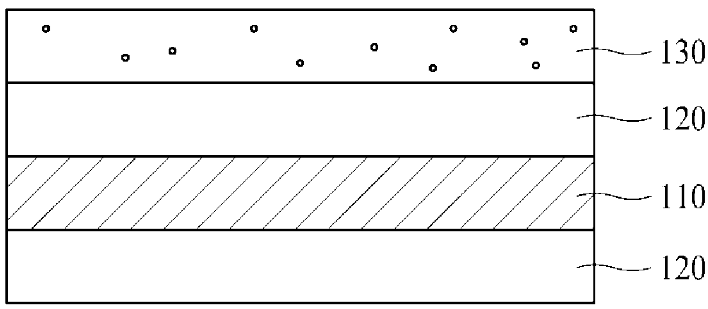

FIG. 6

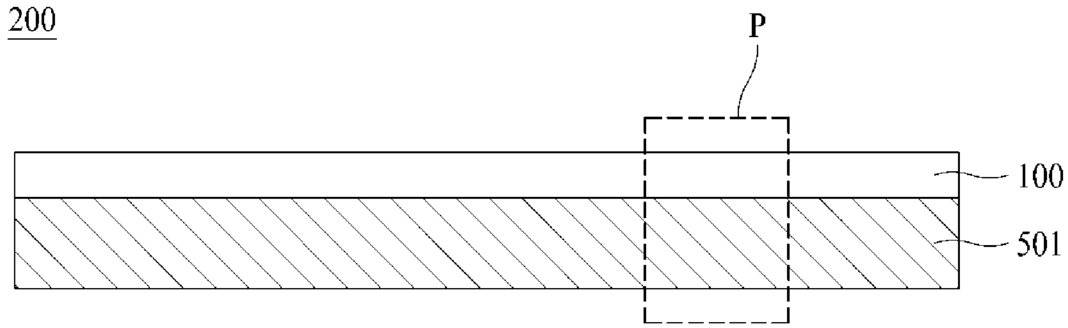

FIG. 7

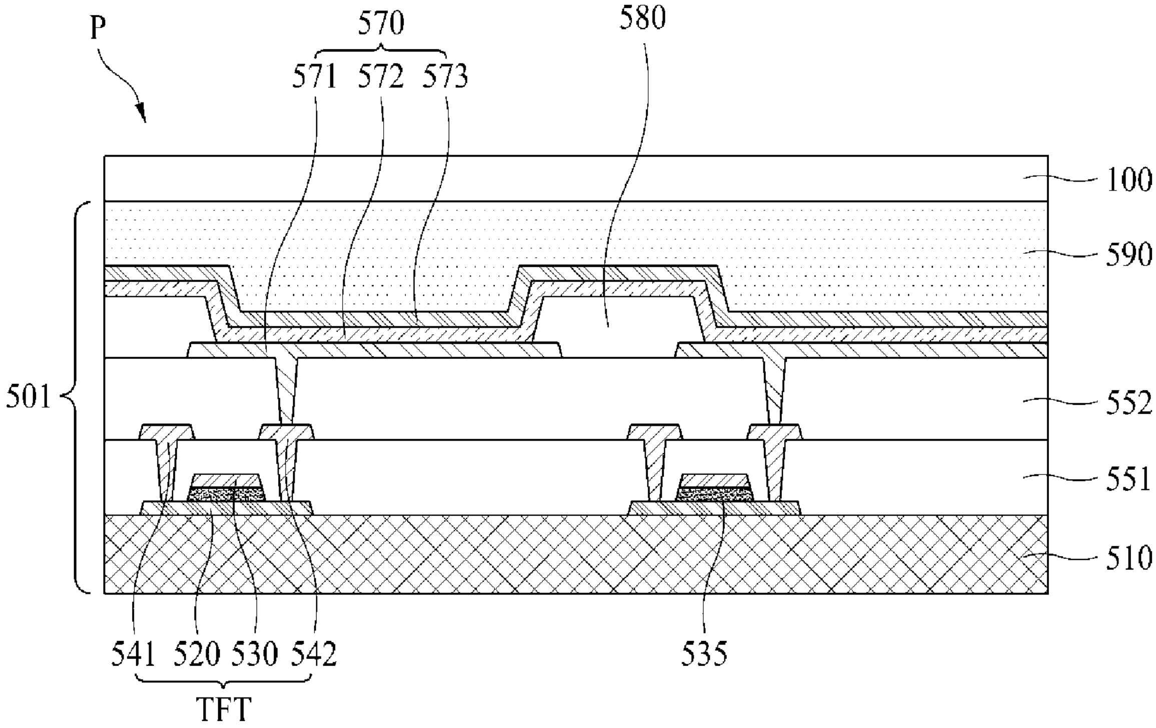
P
570
571 572 573
580
100
590
501
552
551
510
541 520 530 542
TFT
535

**INTERNATIONAL SEARCH REPORT**

International application No.
**PCT/KR2021/003804**

**A. CLASSIFICATION OF SUBJECT MATTER**

**C08J 5/18**(2006.01)i; **C08J 7/04**(2006.01)i; **C08J 7/046**(2020.01)i

According to International Patent Classification (IPC) or to both national classification and IPC

**B. FIELDS SEARCHED**

Minimum documentation searched (classification system followed by classification symbols)

C08J 5/18(2006.01); B32B 7/023(2019.01); B32B 7/12(2006.01); C08J 7/04(2006.01); C09D 183/04(2006.01); C09D 7/40(2018.01); C09J 7/40(2018.01); G02B 5/20(2006.01); G03F 7/004(2006.01); H01L 23/29(2006.01); H01L 23/31(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus), Google & keywords: 버퍼층(buffer layer), 우레탄 아크릴레이트 실록산 수지(urethane acrylate siloxane resin), 테트라알콕시 실란(tetraalkoxy silane), 하드코팅층(hard coating layer)

**C. DOCUMENTS CONSIDERED TO BE RELEVANT**

| Category* | Citation of document, with indication, where appropriate, of the relevant passages | Relevant to claim No. |
|---|---|---|
| A | KR 10-2019-0017895 A (3M INNOVATIVE PROPERTIES COMPANY) 20 February 2019 (2019-02-20) See claims 1, 2, 11, 21, 28 and 32; and paragraphs [0038], [0041], [0044], [0045], [0076] and [0077]. | 1-14 |
| A | KR 10-2019-0058491 A (3M INNOVATIVE PROPERTIES COMPANY) 29 May 2019 (2019-05-29) See claims 1, 3, 5, 6, 7, 10 and 15-18; and paragraphs [0003], [0037], [0038] and [0103]. | 1-14 |
| A | KR 10-2017-0107684 A (DONGWOO FINE-CHEM CO., LTD.) 26 September 2017 (2017-09-26) See claims 1-6; and paragraph [0168]. | 1-14 |
| A | KR 10-1942006 B1 (KOLON INDUSTRIES, INC.) 24 January 2019 (2019-01-24) See claims 1-11. | 1-14 |
| A | JP 2019-067876 A (HOYA CANDEO OPTRONICS CORP.) 25 April 2019 (2019-04-25) See claims 1-5. | 1-14 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **06 July 2021** | **06 July 2021** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2019)

**INTERNATIONAL SEARCH REPORT**
**Information on patent family members**

International application No.
**PCT/KR2021/003804**

| Patent document cited in search report | Publication date (day/month/year) | Patent family member(s) | Publication date (day/month/year) |
|---|---|---|---|
| KR 10-2019-0017895 A | 20 February 2019 | CN 109311289 A | 05 February 2019 |
| | | EP 3468795 A2 | 17 April 2019 |
| | | JP 2019-520608 A | 18 July 2019 |
| | | TW 201815590 A | 01 May 2018 |
| | | US 2019-0211168 A1 | 11 July 2019 |
| | | WO 2017-214105 A2 | 14 December 2017 |
| | | WO 2017-214105 A3 | 08 February 2018 |
| KR 10-2019-0058491 A | 29 May 2019 | CN 109715395 A | 03 May 2019 |
| | | EP 3515703 A1 | 31 July 2019 |
| | | JP 2019-532356 A | 07 November 2019 |
| | | TW 201829170 A | 16 August 2018 |
| | | US 2020-0016868 A1 | 16 January 2020 |
| | | WO 2018-057774 A1 | 29 March 2018 |
| KR 10-2017-0107684 A | 26 September 2017 | None | |
| KR 10-1942006 B1 | 24 January 2019 | CN 107207906 A | 26 September 2017 |
| | | CN 107207906 B | 24 November 2020 |
| | | EP 3241875 A1 | 08 November 2017 |
| | | EP 3241875 B1 | 25 March 2020 |
| | | EP 3591017 A1 | 08 January 2020 |
| | | EP 3591017 B1 | 17 March 2021 |
| | | JP 2018-506617 A | 08 March 2018 |
| | | KR 10-1967146 B1 | 09 April 2019 |
| | | KR 10-1967147 B1 | 09 April 2019 |
| | | US 2018-0010012 A1 | 11 January 2018 |
| | | WO 2016-108676 A1 | 07 July 2016 |
| JP 2019-067876 A | 25 April 2019 | CN 109616566 A | 12 April 2019 |
| | | KR 10-2019-0038364 A | 08 April 2019 |
| | | TW 201924093 A | 16 June 2019 |
| | | US 10658555 B2 | 19 May 2020 |
| | | US 2019-0103529 A1 | 04 April 2019 |

Form PCT/ISA/210 (patent family annex) (July 2019)